# EUROPEAN PATENT APPLICATION

(11) **EP 4 477 784 A1**
(43) Date of publication of application: **18.12.2024**
(21) Application number: 24722100.5
(22) Date of filing: 12.03.2024
(51) Int. Cl.: C25D 3/38, C25D 5/36, C25D 21/14, C25D 21/12, H05K 7/20

(54) **STAINLESS STEEL VAPOR CHAMBER PROCESSING METHOD AND VAPOR CHAMBER**

(30) Priority: 27.04.2023 CN 202310479237
(71) Applicant: Dongguan Lingyi Precision Manufacturing Technology Co., Ltd, Dongguan, Guangdong 523000 (CN)
(72) Inventor: CAI, Ziping, Dongguan, Guangdong 523000 (CN); WANG, Yisheng, Dongguan, Guangdong 523000 (CN); LIANG, Pingping, Dongguan, Guangdong 523000 (CN); LI, Xuehua, Dongguan, Guangdong 523000 (CN)
(74) Representative: Noréns Patentbyrå AB
(86) International application number: PCT/CN2024/081179
(87) International publication number: WO 2024/222249

(57) **Abstract**

A processing method of a stainless steel vapor chamber and a vapor chamber are disclosed. The processing method of the stainless steel vapor chamber includes: connecting a stainless steel upper cover to a first copper body; immersing the first copper body, a second copper body and the stainless steel upper cover into an electrolytic solution; electrically connecting a positive electrode of a power supply to the first copper body, and electrically connecting a negative electrode of the power supply to the second copper body; starting the power supply, and electroplating a porous copper plating layer on a nickel plating layer of the stainless steel upper cover by a hydrogen bubble template method; oxidizing the stainless steel upper cover and the porous copper plating layer at a low temperature; and heating the stainless steel upper cover and the porous copper plating layer in a vacuum.

## Description

### TECHNICAL FIELD

The present disclosure relates to the technical field of heat exchange, and in particular, to a processing method for a stainless steel vapor chamber and a vapor chamber.

### BACKGROUND

Vapor chambers have advantages such as excellent thermal conductivity, large heat transfer area, better temperature uniformity performance and high reliability, and are a primary way to solve the heat dissipation of electronic devices.

At present, to meet the heat dissipation requirement of modern miniaturized electronic devices in the 5G era, the ultra-thin vapor chamber is currently a research hotspot in the industry and academia. A wick structure of the current vapor chamber can be a single structure such as micro-trench, powder sintering, foam metal and silk screen sintering, or a composite structure formed by compounding two types of single structures. However, the wick having the composite structure has a large thickness, and the wick having the single structure is usually difficult to fully regulate the factors including the porosity, capillary pressure, permeability and overall size, which comprehensively determine the excellent capillary performance of the wick of ultra-thin vapor chamber. The capillary performance of the wick plays a decisive role in the performance of the vapor chamber. However, the thickness of the wick is continuously compressed along with the thinner design of the vapor chamber, consequently, the heat transfer performance of the vapor chamber is sharply reduced, and the heat dissipation effect of the vapor chamber is impossible to be ensured.

### SUMMARY

The present disclosure aims to at least solve one of the technical problems in the existing technology. Therefore, the present disclosure provides processing method of a stainless steel vapor chamber, which can form a porous copper plating layer as a wick through electrodeposition so as to realize efficient phase-change heat dissipation.

The present disclosure further provides a vapor chamber prepared by using the processing method of the stainless steel vapor chamber.

A processing method of a stainless steel vapor chamber according to an embodiment of a first aspect of the present disclosure includes the following steps:
connecting a stainless steel upper cover to a first copper body;
immersing the first copper body, a second copper body and the stainless steel upper cover into an electrolytic solution, where the electrolytic solution comprises CuSO₄ and H₂SO₄;
electrically connecting a positive electrode of a power supply to the first copper body, and electrically connecting a negative electrode of the power supply to the second copper body;
starting the power supply, and electroplating a porous copper plating layer on a nickel plating layer of the stainless steel upper cover by a hydrogen bubble template method;
oxidizing the stainless steel upper cover and the porous copper plating layer at a low temperature; and
heating the stainless steel upper cover and the porous copper plating layer in a vacuum.

The processing method of the stainless steel vapor chamber according to an embodiment of the present disclosure at least has the following beneficial effects.

A surface of the stainless steel upper cover is plated with a nickel plating layer, and the stainless steel upper cover is connected to the first copper body, so that the stainless steel upper cover is electrically connected to the first copper body; the stainless steel upper cover, the first copper body and a second copper body are immersed into an electrolytic solution, where the electrolytic solution includes CuSO₄ and H₂SO₄, a positive electrode of a power supply is electrically connected to the first copper body, and a negative electrode of the power supply is electrically connected to the second copper body, so that the copper plating layer can be electrodeposited on the nickel plating layer of the stainless steel upper cover after the power supply is started. In addition to the reduction reaction of copper ions, the process of copper electrodeposition also includes a hydrogen evolution reaction, where hydrogen bubbles are evolved from the nickel plating layer of the stainless steel upper cover, the hydrogen bubbles are used as templates, no deposition layer can be formed in the positions occupied by the bubbles, and the copper ions are reduced and deposited only in gaps among the templates of hydrogen bubbles. The copper ions around the copper deposits are quickly depleted due to the higher deposition rate, and the diffusion of reaction ions from the electrolytic solution to an ion depletion region is interrupted by the continuous evolution of hydrogen; therefore, copper can only continuously grow in gaps among bubbles, and finally a porous copper plating layer having a self-supporting structure with high porosity and specific surface area is obtained. The porous copper plating layer has a liquid working medium with efficient flow and low permeability, and a super-hydrophilic porous copper plating layer is integrally constructed on the surface of the stainless steel upper cover to serve as a wick, so that efficient phase-change heat dissipation is realized; and the thickness of the porous copper plating layer can be controlled by controlling the time of starting the power supply, so that the thickness of the porous copper plating layer can be accurately controlled. After the electroplating is completed, the stainless steel upper cover and the porous copper plating layer are heated at a low temperature in an oxygen environment, and then the stainless steel upper cover and the porous copper plating layer are heated in a vacuum environment, so that an oxide film can be formed on the surface of the stainless steel upper cover to improve the corrosion resistance of the stainless steel upper cover, and the structural stability of the copper plating layer can be strengthened to further improve the working stability of the vapor chamber. The porous copper plating layer formed at the stainless steel upper cover through electrodeposition by the processing method of the stainless steel vapor chamber as described in the present application is served as a wick, so that efficient phase-change heat dissipation is realized, the thickness of the porous copper plating layer can be controlled, and the processing requirements are met.

According to some embodiments of the present disclosure, the step of "starting the power supply, and electroplating a porous copper plating layer on a nickel plating layer of the stainless steel upper cover by a hydrogen bubble template method" includes: adjusting the electrolytic solution to 25 °C; starting the power supply for 25 seconds, wherein the power supply outputs a current with a current density of 0.5 A/cm²; and electroplating the porous copper plating layer on the nickel plating layer of the stainless steel upper cover by a hydrogen bubble template method.

According to some embodiments of the present disclosure, the step of "immersing the first copper body, a second copper body and the stainless steel upper cover into an electrolytic solution, where the electrolytic solution contains CuSO₄ and H₂SO₄" includes: immersing the first copper body, the second copper body and the stainless steel upper cover into the electrolytic solution, where the electrolytic solution consists of 0.2 mol/L of CuSO₄, 1 mol/L of H₂SO₄ and sodium dodecyl sulfate.

According to some embodiments of the present disclosure, before the step of heating the stainless steel upper cover and the porous copper plating layer in a vacuum, the processing method of the stainless steel vapor chamber further includes the following steps: placing a stainless steel lower cover on one side of the stainless steel upper cover plated with the porous copper plating layer; pressing the stainless steel upper cover and the stainless steel lower cover; and performing laser welding on the stainless steel upper cover and the stainless steel lower cover to encapsulate the porous copper plating layer.

According to some embodiments of the present disclosure, the step of heating the stainless steel upper cover and the porous copper plating layer in a vacuum includes: placing the stainless steel upper cover and the stainless steel lower cover in a vacuum environment; and heating the stainless steel upper cover and the stainless steel lower cover to 850 °C for 120 minutes.

According to some embodiments of the present disclosure, the step of oxidizing the stainless steel upper cover and the porous copper plating layer at a low temperature includes: placing the stainless steel upper cover and the porous copper plating layer in an aerobic environment; and heating the stainless steel upper cover and the porous copper plating layer to 500 °C for 120 minutes.

According to some embodiments of the present disclosure, both the first copper body and the second copper body can be phosphor copper or brass.

According to some embodiments of the present disclosure, before the step of connecting a stainless steel upper cover to a first copper body, the processing method of the stainless steel vapor chamber further includes the following steps: immersing the stainless steel upper cover into acetone; immersing the stainless steel upper cover into ethanol; immersing the stainless steel upper cover into deionized water; and immersing the stainless steel upper cover in a 100 mL/L hydrochloric acid solution.

According to some embodiments of the present disclosure, before the step of connecting a stainless steel upper cover to a first copper body, the processing method of the stainless steel vapor chamber further includes the following steps: immersing the stainless steel upper cover into deionized water; electroplating a nickel plating layer on a surface of the stainless steel upper cover; and immersing the stainless steel upper cover into deionized water again.

The vapor chamber according to an embodiment of a second aspect of the present disclosure includes a stainless steel upper cover and a heat dissipation copper plating layer; the stainless steel upper cover includes a stainless steel main body and a nickel plating layer, where the nickel plating layer is arranged on one side of the stainless steel main body; the heat dissipation copper plating layer is arranged on the nickel plating layer, and a surface of the heat dissipation copper sheet is provided with a plurality of micropores.

The vapor chamber according to the embodiment of the present disclosure at least has the following beneficial effects.

The vapor chamber can be prepared by the processing method of the stainless steel vapor chamber according to the embodiment of the first aspect, where a surface of the stainless steel upper cover is plated with a nickel plating layer, and the stainless steel upper cover is connected to the first copper body, so that the stainless steel upper cover is electrically connected to the first copper body; the stainless steel upper cover, the first copper body and a second copper body are immersed into an electrolytic solution, where the electrolytic solution includes CuSO₄ and H₂SO₄, a positive electrode of a power supply is electrically connected to the first copper body, and a negative electrode of the power supply is electrically connected to the second copper body, so that the copper plating layer can be electrodeposited on the nickel plating layer of the stainless steel upper cover after the power supply is started. In addition to the reduction reaction of copper ions, the process of copper electrodeposition also includes a hydrogen evolution reaction, where hydrogen bubbles are evolved from the nickel plating layer of the stainless steel upper cover, the hydrogen bubbles are used as templates, no deposition layer can be formed in the positions occupied by the bubbles, and the copper ions are reduced and deposited only in gaps among the templates of hydrogen bubbles. The copper ions around the copper deposits are quickly depleted due to the higher deposition rate, and the diffusion of reaction ions from the electrolytic solution to an ion depletion region is interrupted by the continuous evolution of hydrogen; therefore, copper can only continuously grow in gaps among bubbles, and finally a porous copper plating layer having a self-supporting structure with high porosity and specific surface area is obtained. The porous copper plating layer has a liquid working medium with efficient flow and low permeability, and a super-hydrophilic porous copper plating layer is integrally constructed on the surface of the stainless steel upper cover to serve as a wick, so that efficient phase-change heat dissipation is realized; and the thickness of the porous copper plating layer can be controlled by controlling the time of starting the power supply, so that the thickness of the porous copper plating layer can be accurately controlled. The heat dissipation copper plating layer is arranged on a nickel plating layer, a plurality of micropores are formed on the surface of a heat dissipation copper sheet, and the multilayer copper plating layer is the heat dissipation copper plating layer. After the electroplating is completed, the stainless steel upper cover and the heat dissipation copper plating layer are heated at a low temperature in an oxygen environment, and then the stainless steel upper cover and the heat dissipation copper plating layer are heated in a vacuum environment, so that an oxide film can be formed on the surface of the stainless steel upper cover to improve the corrosion resistance of the stainless steel upper cover, and the structural stability of the copper plating layer can be strengthened to further improve the working stability of the vapor chamber. The heat dissipation copper plating layer formed at the stainless steel upper cover through electrodeposition by the processing method of the stainless steel vapor chamber is served as a wick, so that efficient phase-change heat dissipation is realized, the thickness of the heat dissipation copper plating layer can be controlled, and the processing requirements are met.

Additional aspects and advantages of the present disclosure will be set forth in part in the following description, some of which will be apparent from the following description, or will be learned by practice of the present disclosure.

### BRIEF DESCRIPTION OF DRAWINGS

The above and/or additional aspects and advantages of the present disclosure will become apparent and readily appreciated from the following description of the embodiments with reference to the accompanying drawings.

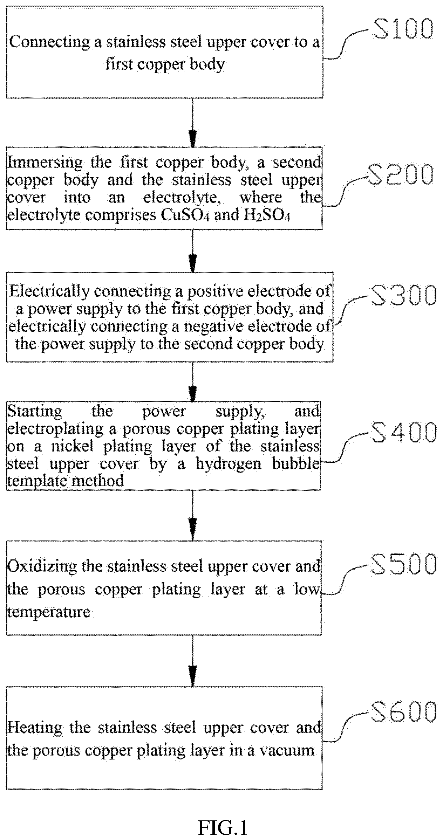

FIG. 1 is a schematic flow chart of a processing method of a stainless steel vapor chamber according to the present disclosure.

### DETAILED DESCRIPTION

Embodiments of the present disclosure will be described in detail below, and illustration of the embodiments are shown in the accompanying drawings, wherein the same or similar reference numerals indicate the same or similar elements or elements having the same or similar functions throughout. The embodiments described below with reference to the accompanying drawings are illustrative only for the purpose of explaining the present disclosure, and are not to be construed as limiting the present disclosure.

In the description of the present disclosure, it should be understood that when directional descriptions are related, for example, directions or positional relationships indicated by terms such as "up", "down", "left", "right", "front", "rear" and the like are those shown based on the accompanying drawings, and are merely intended to facilitate and simplify the description of the present disclosure rather than indicate or imply that the indicated apparatus or element must have a specific direction and must be configured and operated according to the specific direction. Therefore, these directions or positional relationships should not be construed as limiting the present disclosure.

In the description of the present disclosure, unless otherwise explicitly defined, terms such as "provide" "arrange", , "connect" and the like should be understood in a broad sense, and those skilled in the art can reasonably determine the specific meanings of the above terms in the present disclosure in conjunction with the specific contents of the technical solutions.

Referring to FIG. 1, a processing method of a stainless steel vapor chamber according to an embodiment of a first aspect of the present disclosure includes the following steps:
S 100: connecting a stainless steel upper cover to a first copper body;
S200: immersing the first copper body, a second copper body and the stainless steel upper cover into an electrolytic solution, where the electrolytic solution comprises CuSO₄ and H₂SO₄;
S300: electrically connecting a positive electrode of a power supply to the first copper body, and electrically connecting a negative electrode of the power supply to the second copper body;
S400: starting the power supply, and electroplating a porous copper plating layer on a nickel plating layer of the stainless steel upper cover by a hydrogen bubble template method;
S500: oxidizing the stainless steel upper cover and the porous copper plating layer at a low temperature; and
S600: heating the stainless steel upper cover and the porous copper plating layer in a vacuum.

The surface of the stainless steel upper cover is plated with a nickel plating layer, and the stainless steel upper cover is connected to the first copper body, so that the stainless steel upper cover is electrically connected to the first copper body; the stainless steel upper cover, the first copper body and a second copper body are immersed into an electrolytic solution, where the electrolytic solution includes CuSO₄ and H₂SO₄, a positive electrode of a power supply is electrically connected to the first copper body, and a negative electrode of the power supply is electrically connected to the second copper body, so that the copper plating layer can be electrodeposited on the nickel plating layer of the stainless steel upper cover after the power supply is started. In addition to the reduction reaction of copper ions, the process of copper electrodeposition also includes a hydrogen evolution reaction, where hydrogen bubbles are evolved from the nickel plating layer of the stainless steel upper cover, the hydrogen bubbles are used as templates, no deposition layer can be formed in the positions occupied by the bubbles, and the copper ions are reduced and deposited only in gaps among the templates of hydrogen bubbles. The copper ions around the copper deposits are quickly depleted due to the higher deposition rate, and the diffusion of reaction ions from the electrolytic solution to an ion depletion region is interrupted by the continuous evolution of hydrogen; therefore, copper can only continuously grow in gaps among bubbles, and finally a porous copper plating layer having a self-supporting structure with high porosity and specific surface area is obtained. The porous copper plating layer has a liquid working medium with efficient flow and low permeability, and a super-hydrophilic porous copper plating layer is integrally constructed on the surface of the stainless steel upper cover to serve as a wick, so that efficient phase-change heat dissipation is realized; and the thickness of the porous copper plating layer can be controlled by controlling the time of starting the power supply, so that the thickness of the porous copper plating layer can be accurately controlled. After the electroplating is completed, the stainless steel upper cover and the porous copper plating layer are heated at a low temperature in an oxygen environment, and then the stainless steel upper cover and the porous copper plating layer are heated in a vacuum environment, so that an oxide film can be formed on the surface of the stainless steel upper cover to improve the corrosion resistance of the stainless steel upper cover, and the structural stability of the copper plating layer can be strengthened to further improve the working stability of the vapor chamber. The porous copper plating layer formed at the stainless steel upper cover through electrodeposition by the processing method of the stainless steel vapor chamber is served as a wick, so that efficient phase-change heat dissipation is realized, the thickness of the porous copper plating layer can be controlled, and the processing requirements are met.

In some embodiments of the present disclosure, the step of "S400: starting the power supply, and electroplating a porous copper plating layer on a nickel plating layer of the stainless steel upper cover by a hydrogen bubble template method" includes:
adjusting the electrolytic solution to 25 °C;
starting the power supply for 25 seconds, wherein the power supply outputs a current with a current density of 0.5 A/cm² by the power supply; and
electroplating the porous copper plating layer on the nickel plating layer of the stainless steel upper cover by a hydrogen bubble template method.

The temperature of the first copper body, the second copper body and the stainless steel upper cover can be controlled by controlling the temperature of the electrolytic solution, so that an environment temperature in the electroplating process is controlled, and the stability of the electroplating process is ensured.

The electroplating time and the electroplating efficiency can be controlled by controlling the starting time of the power supply and the current output by the power supply, so that the porous copper plating layer can be controlled, and the porous copper plating layer can meet the processing requirement of the ultra-thin vapor chamber.

In some embodiments of the present disclosure, the step of "S200: immersing the first copper body, a second copper body and the stainless steel upper cover into an electrolytic solution, where the electrolytic solution comprises CuSO₄ and H₂SO₄" includes:
immersing the first copper body, the second copper body and the stainless steel upper cover into the electrolytic solution, where the electrolytic solution consists of 0.2 mol/L of CuSO₄, 1 mol/L of H₂SO₄ and sodium dodecyl sulfate.

The first copper body, the second copper body and the stainless steel upper cover are immersed into the electrolytic solution comprising CuSO₄ and H₂SO₄, which can provide a chemical environment for electrodepositing copper. The sodium dodecyl sulfate serving as a chemical reducing agent is introduced into an electrochemical deposition process, so that a plating layer can be induced to generate towards an instantaneous nucleation-growth direction to obtain an electrodeposited plating layer sample, and the electroplating efficiency is improved.

In some embodiments of the present disclosure, before the step of "S600: heating the stainless steel upper cover and the porous copper plating layer in a vacuum", the processing method of the stainless steel vapor chamber further includes the following steps:
placing a stainless steel lower cover on one side of the stainless steel upper cover plated with the porous copper plating layer;
pressing the stainless steel upper cover and the stainless steel lower cover; and
performing laser welding on the stainless steel upper cover and the stainless steel lower cover to encapsulate the porous copper plating layer.

The porous copper plating layer is positioned between the stainless steel upper cover and the stainless steel lower cover, and the stainless steel upper cover and the stainless steel lower cover are pressed together, and the stainless steel upper cover and the stainless steel lower cover are fixedly welded by laser welding, so that the porous copper plating layer can be encapsulated between the stainless steel upper cover and the stainless steel lower cover to protect the porous copper plating layer.

In some embodiments of the present disclosure, the step of "S600: heating the stainless steel upper cover and the porous copper plating layer in a vacuum" further includes:
placing the stainless steel upper cover and the stainless steel lower cover in a vacuum environment; and
heating the stainless steel upper cover and the stainless steel lower cover to 850 °C for 120 minutes.

The wrinkling deformation caused by the welding of stainless steel can be smoothed through vacuum heating of the stainless steel upper cover and the stainless steel lower cover, the porous copper plating layer is further strengthened, and the structural strength of the porous copper plating layer is improved.

In some embodiments of the present disclosure, the step of "S500: oxidizing the stainless steel upper cover and the porous copper plating layer at a low temperature" includes:
placing the stainless steel upper cover and the porous copper plating layer in an aerobic environment; and
heating the stainless steel upper cover and the porous copper plating layer to 500 °C for 120 minutes.

The stainless steel upper cover and the porous copper plating layer are placed in an aerobic environment, so that oxide films can be formed on the surfaces of the stainless steel upper cover and the stainless steel lower cover, and the corrosion resistance of the stainless steel upper cover and the stainless steel lower cover can be improved.

In some embodiments of the present disclosure, both the first copper body and the second copper body can be phosphor copper or brass.

Specifically, the first copper body is brass, the second copper body is phosphorus copper, the phosphorus copper is used as an anode, the brass is used as a cathode. The grains of the phosphorus copper are fine and evenly distributed, so that an anode film is formed quickly and evenly during electroplating, copper ions are released stably, and a copper plating layer formed after electroplating is brighter and even. The brass has high thermal conductivity and good heat conduction efficiency, and thus can conduct heat more efficiently.

In some embodiments of the present disclosure, before the step of connecting a stainless steel upper cover to a first copper body, the processing method of the stainless steel vapor chamber further includes the following steps:
immersing the stainless steel upper cover into acetone;
immersing the stainless steel upper cover into ethanol;
immersing the stainless steel upper cover into deionized water; and
immersing the stainless steel upper cover into a 100 mL/L hydrochloric acid solution.

The stainless steel upper cover is immersed into the acetone, the ethanol and the hydrochloric acid solution, so that oil stains and an oxide layer on the surface of the stainless steel upper cover can be removed, and the stability of subsequent electroplating is improved; the stainless steel upper cover is immersed into deionized water, so that acetone and ethanol attached to the stainless steel upper cover can be cleaned.

In some embodiments of the present disclosure, before the step of connecting a stainless steel upper cover to a first copper body, the processing method of the stainless steel vapor chamber further includes the following steps:
immersing the stainless steel upper cover into deionized water;
electroplating a nickel plating layer on a surface of the stainless steel upper cover; and
immersing the stainless steel upper cover into deionized water again.

By immersed into deionized water, the stainless steel upper cover can be cleaned. The stainless steel upper cover is electroplated with the nickel plating layer, so that the stainless steel upper cover has good corrosion resistance. Specifically, the part of the stainless steel upper cover plated with the nickel plating layer is immersed into the electrolytic solution, so that the stainless steel upper cover is prevented from being corroded by H₂SO₄ in the electrolytic solution.

Referring to FIG. 1, the vapor chamber according to an embodiment of a second aspect of the present disclosure is provided. The vapor chamber includes a stainless steel upper cover and a heat dissipation copper plating layer; the stainless steel upper cover includes a stainless steel main body and a nickel plating layer, where the nickel plating layer is arranged on one side of the stainless steel main body; the heat dissipation copper plating layer is arranged on the nickel plating layer, and a surface of the heat dissipation copper sheet is provided with a plurality of micropores.

The vapor chamber can be prepared by the processing method of the stainless steel vapor chamber according to the embodiment of the first aspect, where a surface of the stainless steel upper cover is plated with a nickel plating layer, and the stainless steel upper cover is connected to the first copper body, so that the stainless steel upper cover is electrically connected to the first copper body; the stainless steel upper cover, the first copper body and a second copper body are immersed into an electrolytic solution, where the electrolytic solution includes CuSO₄ and H₂SO₄, a positive electrode of a power supply is electrically connected to the first copper body, and a negative electrode of the power supply is electrically connected to the second copper body, so that the copper plating layer can be electrodeposited on the nickel plating layer of the stainless steel upper cover after the power supply is started. In addition to the reduction reaction of copper ions, the process of copper electrodeposition also includes a hydrogen evolution reaction, where hydrogen bubbles are evolved from the nickel plating layer of the stainless steel upper cover, the hydrogen bubbles are used as templates, no deposition layer can be formed in the positions occupied by the bubbles, and the copper ions are reduced and deposited only in gaps among the templates of hydrogen bubbles. The copper ions around the copper deposits are quickly depleted due to the higher deposition rate, and the diffusion of reaction ions from the electrolytic solution to an ion depletion region is interrupted by the continuous evolution of hydrogen; therefore, copper can only continuously grow in gaps among bubbles, and finally a porous copper plating layer having a self-supporting structure with high porosity and specific surface area is obtained. The porous copper plating layer has a liquid working medium with efficient flow and low permeability, and a super-hydrophilic porous copper plating layer is integrally constructed on the surface of the stainless steel upper cover to serve as a wick, so that efficient phase-change heat dissipation is realized; and the thickness of the porous copper plating layer can be controlled by controlling the time of starting the power supply, so that the thickness of the porous copper plating layer can be accurately controlled. The heat dissipation copper plating layer is arranged on a nickel plating layer, a plurality of micropores are formed on the surface of a heat dissipation copper sheet, and the multilayer copper plating layer is the heat dissipation copper plating layer. After the electroplating is completed, the stainless steel upper cover and the heat dissipation copper plating layer are heated at a low temperature in an oxygen environment, and then the stainless steel upper cover and the heat dissipation copper plating layer are heated in a vacuum environment, so that an oxide film can be formed on the surface of the stainless steel upper cover to improve the corrosion resistance of the stainless steel upper cover, and the structural stability of the copper plating layer can be strengthened to further improve the working stability of the vapor chamber. The heat dissipation copper plating layer formed at the stainless steel upper cover through electrodeposition by the processing method of the stainless steel vapor chamber is served as a wick, so that efficient phase-change heat dissipation is realized, the thickness of the heat dissipation copper plating layer can be controlled, and the processing requirements are met.

In the description of this specification, the description with reference to the terms "one embodiment", "some embodiments", " illustrative embodiment", "example", "specific example", "some examples" or the like means the particular features, structures, materials or characteristics described in combination with the embodiment or example are included in at least one embodiment or example of the present disclosure. In this specification, the schematic expression of the above terms does not necessarily refer to the same embodiments or examples. Furthermore, the specific features, structures, materials, or characteristics described can be combined in any suitable manner in any one or more embodiments or examples.

Although the embodiments of the present disclosure have been shown and described, it may be understood by those of ordinary skill in the art that various changes, modifications, substitutions, and alterations may be made to these embodiments without departing from the gist and purpose of the present disclosure, and the scope of the present disclosure is defined in the claims and equivalents thereof.

## Claims

1. A processing method of a stainless steel vapor chamber, comprising the following steps:
connecting a stainless steel upper cover to a first copper body;
immersing the first copper body, a second copper body and the stainless steel upper cover into an electrolytic solution, wherein the electrolytic solution comprises CuSO₄ and H₂SO₄;
electrically connecting a positive electrode of a power supply to the first copper body, and electrically connecting a negative electrode of the power supply to the second copper body;
starting the power supply, and electroplating a porous copper plating layer on a nickel plating layer of the stainless steel upper cover by a hydrogen bubble template method;
oxidizing the stainless steel upper cover and the porous copper plating layer at a low temperature; and
heating the stainless steel upper cover and the porous copper plating layer in a vacuum.

2. The processing method of the stainless steel vapor chamber according to claim 1, wherein the step of "starting the power supply, and electroplating a porous copper plating layer on a nickel plating layer of the stainless steel upper cover by a hydrogen bubble template method" comprises:
adjusting the electrolytic solution to 25 °C;
starting the power supply for 25 seconds, wherein the power supply outputs current with a current density of 0.5 A/cm²; and
electroplating the porous copper plating layer on the nickel plating layer of the stainless steel upper cover by a hydrogen bubble template method.

3. The processing method of the stainless steel vapor chamber according to claim 1, wherein the step of "immersing the first copper body, a second copper body and the stainless steel upper cover into an electrolytic solution, wherein the electrolytic solution comprises CuSO₄ and H₂SO₄" comprises:
immersing the first copper body, the second copper body and the stainless steel upper cover into the electrolytic solution, wherein the electrolytic solution consists of 0.2 mol/L of CuSO₄, 1 mol/L of H₂SO₄ and sodium dodecyl sulfate.

4. The processing method of the stainless steel vapor chamber according to claim 1, before the step of heating the stainless steel upper cover and the porous copper plating layer in a vacuum, the processing method of the stainless steel vapor chamber further comprises the following steps:
placing a stainless steel lower cover on one side of the stainless steel upper cover plated with the porous copper plating layer;
pressing the stainless steel upper cover and the stainless steel lower cover; and
performing laser welding on the stainless steel upper cover and the stainless steel lower cover to encapsulate the porous copper plating layer.

5. The processing method of the stainless steel vapor chamber according to claim 4, wherein the step of heating the stainless steel upper cover and the porous copper plating layer in a vacuum comprises:
placing the stainless steel upper cover and the stainless steel lower cover in a vacuum environment; and
heating the stainless steel upper cover and the stainless steel lower cover to 850 °C for 120 minutes.

6. The processing method of the stainless steel vapor chamber according to claim 1, wherein the step of oxidizing the stainless steel upper cover and the porous copper plating layer at a low temperature comprises:
placing the stainless steel upper cover and the porous copper plating layer in an aerobic environment; and
heating the stainless steel upper cover and the porous copper plating layer to 500 °C for 120 minutes.

7. The processing method of the stainless steel vapor chamber according to claim 1, wherein both the first copper body and the second copper body are phosphor copper or brass.

8. The processing method of the stainless steel vapor chamber according to claim 1, before the step of connecting a stainless steel upper cover to a first copper body, the processing method of the stainless steel vapor chamber further comprises the following steps:
immersing the stainless steel upper cover into acetone;
immersing the stainless steel upper cover into ethanol;
immersing the stainless steel upper cover into deionized water; and
immersing the stainless steel upper cover into a 100 mL/L hydrochloric acid solution.

9. The processing method of the stainless steel vapor chamber according to claim 8, before the step of connecting a stainless steel upper cover to a first copper body, the processing method of the stainless steel vapor chamber further comprises the following steps:
immersing the stainless steel upper cover into deionized water;
electroplating a nickel plating layer on a surface of the stainless steel upper cover; and
immersing the stainless steel upper cover into deionized water again.

10. A vapor chamber, comprising:
a stainless steel upper cover comprising a stainless steel main body and a nickel plating layer, wherein the nickel plating layer is arranged on one side of the stainless steel main body; and
a heat dissipation copper plating layer arranged on the nickel plating layer, wherein a surface of the heat dissipation copper sheet is provided with a plurality of micropores.
